# EUROPEAN PATENT SPECIFICATION

(11) **EP 1 508 916 B1**
(45) Date of publication and mention of the grant of the patent: **05.03.2008**
(21) Application number: 03018046.7
(22) Date of filing: 07.08.2003
(51) Int. Cl.: H01L 23/40

(54) **Apparatus for cooling semiconductor devices attached to a printed circuit board**
Vorrichtung zur Kühlung von Halbleiterbauteilen auf Leiterplatten
Appareil de refroidissement des dispositifs semiconducteurs monté sur des circuits imprimés

(43) Date of publication of application: 23.02.2005
(73) Proprietor: Harman Becker Automotive Systems GmbH, 76307 Karlsbad (DE)
(72) Inventor: Schmidberger, Stefan, 94315 Straubing (DE)
(74) Representative: Schmuckermaier, Bernhard

(56) References cited:
- US-A- 5 307 236
- US-A1- 2002 051 341
- US-B1- 6 256 199
- RESEARCH DISCLOSURE, vol. 238, February 2001 (2001-02), pages 238-240, XP001103746

## Description

### BACKGROUND OF THE INVENTION

### 1. Field of the Invention

The present invention relates to an apparatus for cooling semiconductor devices, such as integrated circuits, mounted on a printed circuit board or the like.

### 2. Description of the Prior Art

With the recent increase in the degree of semiconductor integration and the advances in the integration of semiconductor power transistors, the electric power consumed by a single semiconductor device has become so large that there are increasing instances where an element becomes highly heated by the heat generated by itself to lower the reliability.

The heat radiation to cool the semiconductor device is effected by heat transfer from the surface of the heated portion to the surrounding air. Namely, if the resistance of heat transfer between the surface of the heated element and the surrounding air is low, then the heat is well transferred. Therefore, by lowering the heat transfer resistance to the air, better cooling of the heated element is effected. In order to lower the heat transfer resistance to the air, the method to enlarge the surface in contact with the air, i.e. the surface area, has so far been employed.

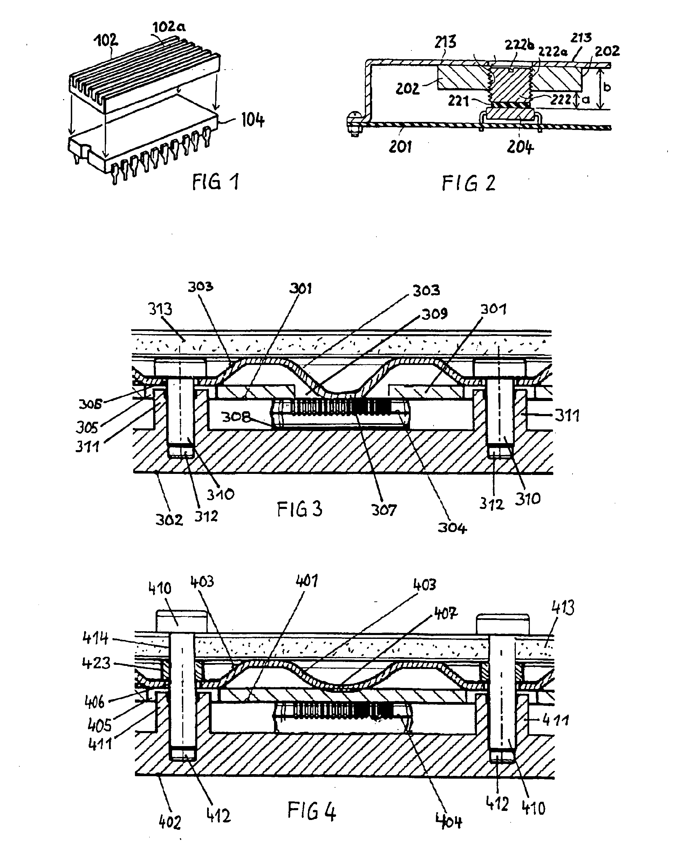

As a device to achieve the above-stated effect, such one as shown in FIG. 1 has so far been used. In FIG. 1, reference numeral 104 denotes an integrated circuit, IC. The one shown in FIG. 1 is of Dual-In-Line package type but could be of any other type of housing applicable with semiconductor devices. Reference numeral 102 denotes a radiating fin, which is made of metal such as copper, aluminum, or the like, having good heat conductivity, and the radiating fin is provided with fine grooves 102a on the top face thereof to magnify the surface area in contact with the air. The radiating fin 102 is attached to the top face of the IC 104, a semiconductor device, by means of adhesive, or nuts and bolts. The heat generated by the IC 104 is thus conducted to the radiating fin 102 for cooling.

The method to attach the radiating fin 102 directly to the IC 104 appears to be effective upon initial consideration, but it involves various problems in reality.

Firstly, the direction of the grooves 102a to magnify the surface area of the radiating fin 102 must be in the direction of the air flow. By this arrangement to improve the radiation effect, the direction of the IC 104 to be mounted on the printed circuit board is restricted to be in one direction. As a result, the wiring pattern on the printed circuit board is also subject to restriction.

Secondly, the means used for attaching the radiating fin 102 to IC 104 involves problems. The means for attaching the radiating fin 102 to IC 104 must endure thermal stress for a long time, so that the radiating fin 102 is held securely attached to the IC 104 even when subject to vibration or shock. However, said means must be adapted such that, under all possible thermal conditions, the semiconductor device does not experience excessive contact pressure resulting from the attaching means.

To achieve this, US 4,621,304 to Oogaki et al. proposes an adapted construction of a heat sink as indicated in present FIG. 2 to adjust the height (b).

As indicated in FIG. 2, first and second heat sink 202, 222 are provided. The second heat sink 222 is of cylindrical shape and provided with a thread 222a on the periphery thereof and with a slot 222b on the top face thereof so as to be driven by a screwdriver. The first heat sink 202 attached to a shield case 213 is provided with a female thread 202a, so that the threaded heat sink 222 can be engaged therewith. The threaded heat sink 222 is adapted to be threadedly engaged with the female thread 202a of the first heat sink 202 from above the shield case 213, to which the heat sink 202 is attached, through a hole 213a.

The threaded heat sink 222 is passed through the hole 213a at the top of the shield case 213 and threadedly engaged with the threaded portion 202a of the heat sink 202. The heat sink 222 is pressed against an IC 204 mounted on a printed circuit board 201. In order to make smooth the contact and the heat conduction between the threaded heat sink 222 and an IC 204, a heat conductive rubber 221 with good heat conductivity may be previously attached to the former at its portion which contacts the latter. In such a case, the threaded heat sink 222 contacts with the IC 204 through the rubber 221. Thus, any variation in the distance (a) between the electronic parts 204 and the heat sink 202 can be minutely compensated with ease by turning the threaded heat sink 222. Meanwhile, the heat sink 202 and the threaded heat sink 222 are in threaded contact and therefore the surface of contact between them is magnified, so that the heat conducted from the electronic parts 204 through the rubber 221 to the threaded heat sink 222 is easily conducted to the heat sink 202, and emitted to the ambient air through the shield case 213. As described in the foregoing, no matter how varied the distances between the first heat sink 202 and the electronic parts 204 may be, sufficient pressure of contact and surface of contact for good heat conductivity is always obtained by virtue of the second heat sink 222.

However, the conventional apparatus shown in FIG. 2 still exhibits some limitations as, for example, a costly manufacturing process, a multitude of specific parts, and unreasonable weight and height in view of the cooling effect achieved.

In the publication "Research Disclosure, vol. 328, February 2001, pp. 238-240, XP0001103746" a heat sink to motherboard microprocessor mounting scheme is described. A device on the motherboard is pushed against a heat sink by springs which are positioned between heads of bolts and the motherboard wherein the bolts are screwed into the heat sink. For each bolt a separate spring is needed for applying equal pressure between the heat sink and the device.

The spring member described in US 2002/0051341A1 is a flat plate fastened at the outer edges of the plate to a substrate. Between the substrate and the spring member a circuit package and a stack of heatpipe for cooling the circuit board are located. The spring member is equipped with a dome through which a centering pressure is applied between the cooling stack and the circuit package. Disadvantageous is that the alignment of the stack with respect to the circuit board depends not only on the force applied by the dome but on additional mechanical elements which can cause inhomogeneous pressure between the stack and the circuit board.

In US 6,256,199 B1 a cartridge including a heat pipe is used as a housing to cover a bottom side of a substrate including a plurality of pins. The cartridge is located on the opposite side of the substrate with respect to a spring clip pressing the substrate against the cartridge. The force inserted into the substrate by the spring clip can only be influenced by a connection between the cartridge and the spring clip but not by the cartridge itself.

### SUMMARY OF THE INVENTION

To overcome the limitations in the related art as described above, and to overcome other limitations that will become apparent upon reading and understanding the following specification, the present invention discloses an improved apparatus for cooling semiconductor devices attached to a printed circuit board.

The preferred apparatus for cooling semiconductor devices attached to a printed circuit board comprises: a printed circuit board having first and second sides, said first side having a semiconductor device attached thereto, said printed circuit board further comprises a plurality of apertures formed through said first and second sides; a cooling member adjacent said first side of the printed circuit board and being in thermal contact with the semiconductor device; a spring member adjacent said second side of the printed circuit board; and securing members connecting the spring member to the cooling member through said apertures in the printed circuit board such that the spring member providing a spring force forcing the semiconductor device against the cooling member.

Therefore, a positive cooling effect is achieved regardless of mounting conditions and the position of the semiconductor device on the cooling plate. Further, the manufacturing process is less costly, less parts are needed, and less weight and less height are.

### BRIEF DESCRIPTION OF THE DRAWINGS

The invention can be better understood with reference to the following drawings and description. The components in the figures are not necessarily to scale, emphasis instead is being placed upon illustrating the principles of the invention. In the drawings:
FIG. 1 is a perspective view of a conventional heat radiator assembly for a semiconductor device;
FIG. 2 is a perspective view of another conventional heat radiator assembly for a semiconductor device;
FIG. 3 is a sectional view of an embodiment of the invention showing a printed circuit board sandwiched between a cooling plate and a spring plate, said spring plate providing a spring force directly to a semiconductor device mounted on the printed circuit board;
FIG. 4 is a sectional view of a comparative example showing another printed circuit board sandwiched between a cooling plate and a spring in connection with a cover plate, said spring plate providing a spring force via the printed circuit board to a semiconductor device mounted on the printed;
FIG. 5 is a sectional view of a comparative example showing another printed circuit board sandwiched between a cooling plate and a spring plate, said spring plate being connected to the cooling plate by means of integral noses;
FIG. 6 is a sectional view of a comparative example showing another printed circuit board sandwiched between a cooling plate and a spring plate, said spring plate being connected to the cooling plate by bolts; and
FIG. 7 is a sectional view of a comparative example showing another printed circuit board sandwiched between a cooling plate and a spring plate, said printed circuit board having two semiconductor devices mounted thereon.

### DETAILED DESCRIPTION

The present invention provides an apparatus for cooling semiconductor devices attached to a printed circuit board. As shown in FIG. 3, such printed circuit board 301 is sandwiched between a cooling member established by a cooling plate 302 and a spring member established by a spring plate 303.

The printed circuit board 301 is a plate of electrically non-conductive material (e. g. resin plate, cermic substrate) comprising at least one structured electrically conductive layer (e g. metallization) for connecting electrical devices such as semiconductor devices. The printed circuit board 301 has first and second sides and further comprises a plurality of apertures 305 formed through said first and second sides. The first side of the printed circuit board 301 comprises a semiconductor device 304 (e. g. power amplifier, voltage regulator, power switch) attached thereto, e. g. by soldering. In FIG. 3 the printed circuit board 301 comprises a further aperture 309 arranged such that it is covered by the semiconductor device 304.

The cooling plate 302 is adjacent said first side of the printed circuit board 301 and has first and second sides itself. The second side of the cooling plate 302 has thermal contact with the semiconductor device 304. In order to further improve the thermal contact, a heat conductive means 308, e. g. a thermal compound, may be applied between the semiconductor device 304 and the cooling plate 302. Additionally or alternatively electrically insulating means may be provided between the semiconductor device 304 and the cooling plate 302. For the purpose of having good heat conductivity, the cooling plate 302 is made of metal and may be provided with fine grooves on the first side thereof to magnify the surface area in contact with the air (not shown in the FIGs.).

The spring plate 303 is made of metal and arranged adjacent said second side of the printed circuit board 301. It is wave-like embossed such that it comprises a dome 307. The dome 307 is located in the further aperture 309 of the printed circuit board 301 and has a height relative to its ground line that exceeds the heights of all other waves or domes due to embossing so that the dome 307 is in direct contact with the semiconductor device 304 and exerting force to the semiconductor device 304 as a result of the spring force provided by the spring plate 303. The spring plate 303 comprises apertures 306 corresponding to the apertures 305 of the printed circuit board 301.

In order to connect the spring plate 303 to the cooling plate 302, securing members are provided which extend through the apertures 305 of the printed circuit board 301 and the apertures 306 of the spring plate 303. In the apparatus of FIG. 3, the securing members are bolts 310 in connection with integral noses 311 formed in a single piece from the cooling plate 302. The integral noses 311 extend partly into the apertures 305 while the bolts 310 extend throught the apertures 305 and 306 into tap holes 312 arranged in the integral noses 311. As the case may be, a cover plate 313 may be arranged adjacent to the spring plate 302 as an outside surface opposite to the outside surface established by the cooling plate 302.

The apparatus shown in FIG. 3 can be easily mounted. Starting with the cooling plate 302 as a base plate, the printed circuit board 301 with the semiconductor device 304 mounted thereon is arranged on the base plate with the semiconductor device 304 face down. It is apparent from the drawings, that the height of the semiconductor device 304 exceeds all other elements arranged on this side of the printed circuit board 301. The third and last step is just to screw the bolts 310 into the tap holes 312. In the apparatus of FIG. 3, the spring force provided by the spring plate 303 depends essentially on the material used, its structure, its thickness, and the size of the dome 307.

As illustrated above, the spring plate 303 provides a spring force forcing the semiconductor device 304 against the cooling plate 302 and, thus, providing an excellent thermal contact between the semiconductor device 304 and the cooling plate 302. The cooling plate 302 has a lower heat transfer resistance to the air due to a larger surface in contact with the air.

In the comparative example shown in FIG. 4, again a printed circuit board 401 is sandwiched between a cooling plate 402 and a spring plate 403.

Like the one illustrated in FIG. 3, the printed circuit board 401 is a plate of electrically non-conductive material comprising at least one structured electrically conductive layer. The printed circuit board 401 has first and second sides and comprises a plurality of apertures 405 formed through said first and second sides. On the first side of the printed circuit board 401 a semiconductor device 404 is arranged.

The cooling plate 402 made of heat conducting material is adjacent said first side of the printed circuit board 401 and has first and second sides itself. The second side of the cooling plate 402 has direct thermal contact with the semiconductor device 404, i. e. no conductive means as mentioned with reference to FIG. 3 is used.

The spring plate 403 is arranged adjacent said second side of the printed circuit board 402 and may be wave-like embossed such that it comprises at least one dome 407. The dome 407 is preferably located in that area of the printed circuit board 401 where on the other side the semiconductor device 404 is attached, and is preferably higher than all other waves or domes of the spring plate 403. Thus, the dome 407 forces the semiconductor device 404 against the cooling plate 402 by means of the printed circuit board 401. The spring plate 403 comprises apertures 406 corresponding to the apertures 405 of the printed circuit board 401, and has on its outer side a cover member established by a cover plate 413 attached thereto.

In order to connect the cover plate 413 to the spring plate 403 and both to the cooling plate 402, bolts 410 serving as securing members are provided which extend through apertures 414 in the cover plate 413, spacer leeves 423, the apertures 405 of the printed circuit board 401, and the apertures 406 of the spring plate 403 and are screwed into tap holes 412 arranged in integral noses 411 formed in a single piece from the cooling plate 402.

As already mentioned above, the height of the semiconductor device 404 exceeds all other elements arranged on this side of the printed circuit board 401.

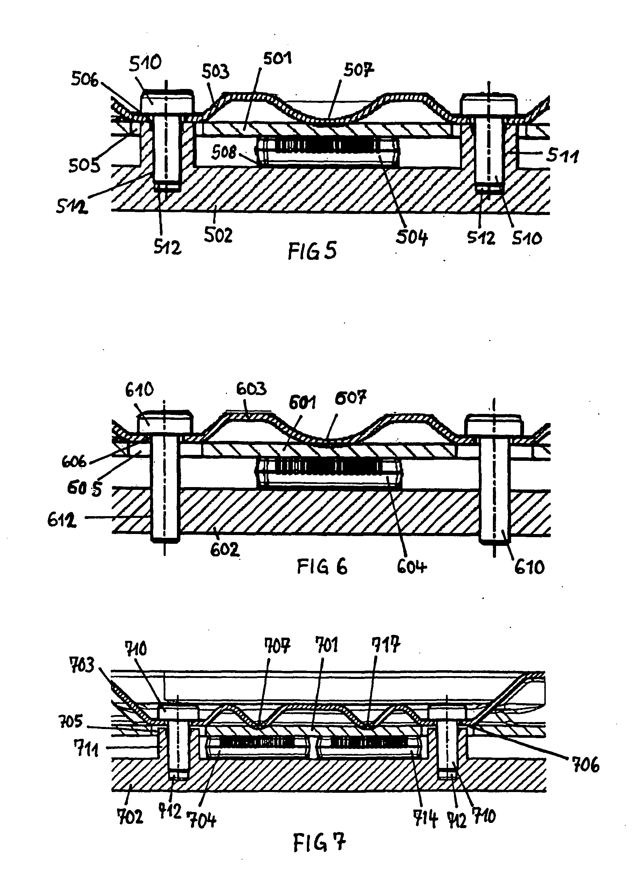

In the comparative example shown in FIG. 5, a printed circuit board 501 is sandwiched between a cooling plate 502 and a spring plate 503. The printed circuit board 501, the cooling plate 502, and the spring plate 503 are like those illustrated in FIGs. 3 and 4.

The printed circuit board 501 has first and second sides and comprises a plurality of apertures 505 formed through said first and second sides. On the first side of the printed circuit board 501 a semiconductor device 504 is arranged.

The cooling plate 502 is adjacent said first side of the printed circuit board 501 and has first and second sides itself. The second side of the cooling plate 502 has thermal contact with the semiconductor device 504, said thermal contact is improved by heat conductive means 508, e. g. a thermal compound applied between the semiconductor device 504 and the cooling plate 502.

The spring plate 503 is arranged adjacent said second side of the printed circuit board 502 and is wave-like embossed such that it comprises a dome 507. The dome 507 is preferably located in that area of the printed circuit board 501 where on the other side the semiconductor device 504 is attached and is preferably higher than all other waves or domes of the spring plate 503. Thus, the dome 507 forces the semiconductor device 504 against the cooling plate 502 by exerting force to the printed circuit board 501 which exerts force to the semiconductor device 504. The spring plate 503 comprises apertures 506 corresponding to the apertures 505 of the printed circuit board 501.

In order to connect the spring plate 503 to the cooling plate 502, bolts 510 serving as securing means are provided which extend through the apertures 505 of the printed circuit board 501, and the apertures 506 of the spring plate 503 and are screwed into tap holes 512 arranged in integral noses 511 formed in a single piece from the cooling plate 502. The height of the semiconductor device 504 exceeds all other elements arranged on this side of the printed circuit board 501.

The comparative example of FIG. 6 is similar to the apparatus shown in FIG. 5, wherein, again, a printed circuit board 601 comprising a semiconductor device 604 is sandwiched between a cooling plate 602 and a spring plate 603. However, the cooling plate 602 comprises no integral noses as the cooling plate 502 of FIG. 5. Instead, tap holes 612 corresponding to apertures 605 in the printed circuit board 601 and apertures 606 in the spring plate 603 are inserted into the cooling plate 602. Bolts 610 extending through the apertures 605 and 606 are screwed into the tap holes 611. Since the cooling plate comprises no noses which would provide counter print to the spring plate 603 as in FIGs. 3-5, the torque provided by the bolts 610 controls the spring force forcing the semiconductor device 604 against the cooling plate 602. This means that by screwing the bolts 610 more or less into the tap holes 611, the spring force pressing the semiconductor device 604 against the cooling plate 602 can easily be adjusted. In the apparatus of FIG. 6, as well as in the apparatus of FIG. 5, the respective spring plates 603, 503 also serve as covers.

The comparative example of FIG. 7 is similar to the apparatus shown in FIG. 5, wherein, however, a printed circuit board 701 having two semiconductor devices 704 and 714 is sandwiched between a cooling plate 702 and a spring plate 703.

The printed circuit board 701 has first and second sides and comprises a plurality of apertures 705 formed through said first and second sides. On the first side of the printed circuit board 701 the two semiconductor devices 704 and 714 are arranged.

The cooling plate 702 is adjacent said first side of the printed circuit board 701 and has first and second sides itself. The second side of the cooling plate 702 has thermal contact with the semiconductor devices 704 and 714, which is improved by heat conductive means 708 and 718.

The spring plate 703 is arranged adjacent said second side of the printed circuit board 702 and is wave-like embossed such that it comprises at least two domes 707 and 717. The domes 707 and 717 are located in that areas of the printed circuit board 701 where on the other side the semiconductor devices 704 and 714 are attached respectively. Both domes 707 and 717 have the same height and are as high as or higher than all other waves or domes of the spring plate 703. Thus, the domes 707 and 717 force the semiconductor devices 704 and 714 against the cooling plate 702 by exerting force to the printed circuit board 701 which exerts force to the semiconductor devices 704 and 714. The spring plate 703 comprises apertures 706 corresponding to the apertures 705 of the printed circuit board 701.

In order to connect the spring plate 703 to the cooling plate 702, bolts 710 serving as securing members are provided which extend through the apertures 705 of the printed circuit board 701, and the apertures 706 of the spring plate 703 and are screwed into tap holes 712 arranged in integral noses 711 formed in a single piece from the cooling plate 702. The semiconductor devices 704 and 714 have the same height which exceeds all other elements arranged on this side of the printed circuit board 701.

It will be apparent to those skilled in the art that various changes and modifications of the embodiment of the invention can be made which achieve some of the advantages of the invention. It will be obvious to those reasonably skilled in the art that other components performing the same functions may be suitably substituted. For example, with all embodiments comprising threaded blind holes as tap holes alternatively threaded contact holes may be used and vice versa. The spring plate may be made of rubber or plastic instead of metal. The semiconductor devices may be integrated circuits or discrete devices in all available and possible packages, e. g. Dual-In-Line (DIL) packages or power packages, preferably PowerS036.

## Claims

1. An apparatus for cooling semiconductor devices (304) attached to a printed circuit board (301), said apparatus comprising:
a printed circuit board (301) having first and second sides, said first side having a semiconductor device (304) attached thereto, said printed circuit board (301) further comprising a plurality of apertures (305) formed through said first and second sides;
a cooling member (302) adjacent said first side of the printed circuit board (301) and being in thermal contact with the semiconductor device (304);
a spring member (303) adjacent said second side of the printed circuit board (301); and
securing members (310, 311) connecting the spring member (303) to the cooling member (302) through said apertures (305) in the printed circuit board (301) such that the spring member (303) provides a spring force forcing the semiconductor device (304) against the cooling member (302),
**characterized in that**
the spring member (303) comprises a dome (307); and the printed circuit board (301) comprises a further aperture (309); said dome (307) located in said further aperture (309) being in contact with the semiconductor device (304).

2. The apparatus of claim 1, wherein the spring member (303) has first and second sides and comprises a plurality of apertures (306) formed through said first and second sides; and
wherein the securing members (310, 311) extends through said apertures (306) in the spring member (303).

3. The apparatus of claim 2, wherein said first side of the spring member (303) is adjacent to the second side of the printed circuit board (301); and
wherein said apparatus further comprises a cover member (313) adjacent said second side of the spring member (303); said cover member (313) being connected to the spring member (303).

4. The apparatus of one of the preceding claims, wherein the securing members (310, 311) are bolts (310).

5. The apparatus of claim 4, wherein the cooling member (302) comprises tap holes (312) into which the bolts (310) are screwed.

6. The apparatus of claim 5, wherein the bolts (310) are screwed with a certain torque and said torque is adjustable in order to adjust the spring force provided by the spring member (303).

7. The apparatus of one of the preceding claims, wherein the spring force provided by the spring member (303) is adjustable by the dome size.

8. The apparatus of one of the preceding claims, wherein the securing members (310, 311) are integral noses (311) formed in a single piece from the cooling member (302).

9. The apparatus of claim 8, wherein the spring member (303) is secured to the integral noses (311) by a threaded connection.

10. The apparatus of one of the preceding claims, wherein a thermal conductive layer (308) is arranged between the semiconductor device (304) and the cooling member (302).

11. The apparatus of one of the preceding claims, wherein the spring member (303) is wave-like embossed.

12. The apparatus of one of the preceding claims, wherein the spring member (303) is a spring plate.

13. The apparatus of one of the preceding claims, wherein the cooling member (302) is a cooling plate.

14. The apparatus of one of the preceding claims, wherein the cover member (313) is a cover plate.

## Patentansprüche

1. Vorrichtung zur Kühlung von auf einer gedruckten Leiterplatte (301) befestigten Halbleiterbauteilen (304), wobei besagte Vorrichtung Nachfolgendes aufweist:
eine gedruckte Leiterplatte (301), die erste und zweite Seiten aufweist, wobei besagte erste Seite ein auf dieser befestigtes Halbleiterbauteil (304) aufweist, besagte gedruckte Leiterplatte (301) weiterhin eine Vielzahl von durch besagte erste und zweite Seiten hindurch ausgeformte Öffnungen (305) aufweist;
ein Kühlelement (302), angrenzend zu besagter ersten Seite der gedruckten Leiterplatte (301) und in thermischem Kontakt mit dem Halbleiterbauteil (304) stehend;
ein Federelement (303), angrenzend zu besagter zweiten Seite der gedruckten Leiterplatte (301) ; und
Befestigungselemente (310, 311), die das Federelement (303) durch besagte Öffnungen (305) in der gedruckten Leiterplatte (301) so mit dem Kühlelement (302) verbinden, dass das Federelement (303) eine Federkraft zur Verfügung stellt, die das Halbleiterbauteil (304) gegen das Kühlelement (302) drückt,
**dadurch gekennzeichnet, dass**
das Federelement (303) eine Wölbung (307) aufweist; und die gedruckte Leiterplatte (301) eine weitere Öffnung (309) aufweist; wobei besagte in besagter weiterer Öffnung (309) angeordnete Wölbung (307) in Kontakt mit dem Halbleiterbauteil (304) steht.

2. Vorrichtung nach Anspruch 1, wobei das Federelement (303) erste und zweite Seiten aufweist und eine Vielzahl durch besagte erste und zweite Seiten hindurch ausgeformte Öffnungen (306) aufweist; und
wobei sich die Befestigungselemente (310, 311) durch besagte Öffnungen (306) in dem Federelement (303) erstrecken.

3. Vorrichtung nach Anspruch 2, wobei besagte erste Seite des Federelements (303) an die zweite Seite der gedruckten Leiterplatte (301) angrenzt; und
wobei besagte Vorrichtung angrenzend zu besagter zweiten Seite des Federelements (303) weiterhin ein Abdeckelement (313) aufweist; wobei besagtes Abdeckelement (313) mit dem Federelement (303) verbunden ist.

4. Vorrichtung nach einem der vorherigen Ansprüche, wobei die Befestigungselemente (310, 311) Schrauben (310) sind.

5. Vorrichtung nach Anspruch 4, wobei das Kühlelement (302) Gewindebohrungen (312) aufweist, in die die Schrauben (310) geschraubt sind.

6. Vorrichtung nach Anspruch 5, wobei die Schrauben (310) mit einem bestimmten Drehmoment geschraubt sind, und besagtes Drehmoment anpassbar ist, um die Federkraft einzustellen, die durch das Federelement (303) zur Verfügung gestellt wird.

7. Vorrichtung nach einem der vorherigen Ansprüche, wobei die durch das Federelement (303) zur Verfügung gestellte Federkraft durch die Wölbungsgröße einstellbar ist.

8. Vorrichtung nach einem der vorherigen Ansprüche, wobei die Befestigungselemente (310, 311) integrale, in einem Stück durch das Kühlelement (302) ausgeformte Nasen (311) sind.

9. Vorrichtung nach Anspruch 8, wobei das Federelement (303) durch eine Gewindeverbindung an den integralen Nasen (311) befestigt ist.

10. Vorrichtung nach einem der vorherigen Ansprüche, wobei eine thermische leitfähige Schicht (308) zwischen dem Halbleiterbauteil (304) und dem Kühlelement (302) angeordnet ist.

11. Vorrichtung nach einem der vorherigen Ansprüche, wobei das Federelement (303) wellenförmig geprägt ist.

12. Vorrichtung nach einem der vorherigen Ansprüche, wobei das Federelement (303) eine Federplatte ist.

13. Vorrichtung nach einem der vorherigen Ansprüche, wobei das Kühlelement (302) eine Kühlplatte ist.

14. Vorrichtung nach einem der vorherigen Ansprüche, wobei das Abdeckelement (313) eine Abdeckplatte ist.

## Revendications

1. Appareil pour refroidir des dispositifs semi-conducteurs (304) fixés sur une carte de circuit imprimé (301), ledit appareil comprenant :
une carte de circuit imprimé (301) ayant des premier et second côtés, ledit premier côté ayant un dispositif semi-conducteur (304) fixé sur celui-ci, ladite carte de circuit imprimé (301) comprenant en outre une pluralité d'ouvertures (305) formées à travers lesdits premier et second côtés ;
un élément de refroidissement (302) adjacent audit premier côté de la carte de circuit imprimé (301) et étant en contact thermique avec le dispositif semi-conducteur (304) ;
un élément de ressort (303) adjacent audit second côté de la carte de circuit imprimé (301) ; et
des moyens de fixation (310, 311) raccordant l'élément de ressort (303) à l'élément de refroidissement (302) par le biais desdites ouvertures (305) dans la carte de circuit imprimé (301) de sorte que l'élément de ressort (303) fournit une force de rappel forçant le dispositif semi-conducteur (304) contre l'élément de refroidissement (302),
**caractérisé en ce que** :
l'élément de ressort (303) comprend un dôme (307) ; et la carte de circuit imprimé (301) comprend une autre ouverture (309) ; ledit dôme (307) situé dans ladite autre ouverture (309) étant en contact avec le dispositif semi-conducteur (304).

2. Appareil selon la revendication 1, dans lequel l'élément de ressort (303) a des premier et second côtés et comprend une pluralité d'ouvertures (306) formées à travers lesdits premier et second côtés ; et
dans lequel les éléments de fixation (310, 311) s'étendent à travers lesdites ouvertures (306) dans l'élément de ressort (303).

3. Appareil selon la revendication 2, dans lequel ledit premier côté de l'élément de ressort (303) est adjacent au second côté de la carte de circuit imprimé (301) ; et
dans lequel ledit appareil comprend en outre un autre élément de couvercle (313) adjacent audit second côté de l'élément de ressort (303) ; ledit élément de couvercle (313) étant raccordé à l'élément de ressort (303).

4. Appareil selon l'une quelconque des revendications précédentes, dans lequel les éléments de fixation (310, 311) sont des boulons (310).

5. Appareil selon la revendication 4, dans lequel l'élément de refroidissement (302) comprend des trous taraudés (312) dans lesquels les boulons (310) sont vissés.

6. Appareil selon la revendication 5, dans lequel les boulons (310) sont vissés avec un certain couple et ledit couple est ajustable afin d'ajuster la force de rappel fournie par l'élément de ressort (303).

7. Appareil selon l'une quelconque des revendications précédentes, dans lequel la force de rappel fournie par l'élément de ressort (303) est ajustable par la taille du dôme.

8. Appareil selon l'une quelconque des revendications précédentes, dans lequel les éléments de fixation (310, 311) sont des nez monobloc (311) formés d'un seul tenant à partir de l'élément de refroidissement (302).

9. Appareil selon la revendication 8, dans lequel l'élément de ressort (303) est fixé sur les nez monobloc (311) par un raccordement fileté.

10. Appareil selon l'une quelconque des revendications précédentes, dans lequel une couche conductrice thermique (308) est agencée entre le dispositif semi-conducteur (304) et l'élément de refroidissement (302).

11. Appareil selon l'une quelconque des revendications précédentes, dans lequel l'élément de ressort (303) est bosselé en forme de vague.

12. Appareil selon l'une quelconque des revendications précédentes, dans lequel l'élément de ressort (303) est une plaque de ressort.

13. Appareil selon l'une quelconque des revendications précédentes, dans lequel l'élément de refroidissement (302) est une plaque de refroidissement.

14. Appareil selon l'une quelconque des revendications précédentes, dans lequel l'élément de couvercle (313) est une plaque de couvercle.
